# EUROPÄISCHE PATENTANMELDUNG

(11) **EP 4 318 554 A1**
(43) Veröffentlichungstag der Anmeldung: **07.02.2024**
(21) Anmeldenummer: 22188328.3
(22) Anmeldetag: 02.08.2022
(51) Int. Cl.: H01L 21/48, H01L 23/373, H01L 23/46, H01L 23/00, H01L 25/07, H01L 23/498, H01L 23/538

(54) **HALBLEITERMODUL MIT ZUMINDEST EINER ERSTEN HALBLEITERANORDNUNG, EINER ZWEITEN HALBLEITERANORDNUNG UND EINEM KÜHLKÖRPER**

(71) Anmelder: Siemens Aktiengesellschaft, 80333 München (DE)
(72) Erfinder: Nährig, Matthias, 91334 Hemhofen (DE); Schmenger, Jens, 91301 Forchheim (DE)
(74) Vertreter: Siemens Patent Attorneys

(57) **Zusammenfassung**

Die Erfindung betrifft ein Halbleitermodul (2) mit zumindest einer ersten Halbleiteranordnung (4), einer zweiten Halbleiteranordnung (6) und einem gemeinsamen Kühlkörper (14), wobei der Kühlkörper (14) konfiguriert ist, dass ein Kühlfluid in eine Kühlfluidströmungsrichtung (18) geleitet wird, wobei die Halbleiteranordnungen (4, 6) auf einer Oberfläche (12) des Kühlkörpers (14) angeordnet sind, wobei die Halbleiteranordnungen (4, 6) jeweils ein Substrat (22, 24) aufweisen, auf welchem jeweils mindestens ein Halbleiterelement (28), insbesondere stoffschlüssig, verbunden ist, wobei die Substrate (22, 24) jeweils eine dielektrische Materiallage (30, 32) umfassen. Um eine verbesserte Zuverlässigkeit zu erreichen, wird vorgeschlagen, dass sich eine zweite dielektrische Materiallage (32) der zweiten Halbleiteranordnung (6) von einer ersten dielektrischen Materiallage (30) der ersten Halbleiteranordnung (4) zumindest hinsichtlich ihrer Wärmeleitfähigkeit unterscheidet.

## Beschreibung

Die Erfindung betrifft ein Halbleitermodul mit zumindest einer ersten Halbleiteranordnung, einer zweiten Halbleiteranordnung und einem gemeinsamen Kühlkörper.

Ferner betrifft die Erfindung einen Stromrichter mit mindestens einem derartigen Leistungshalbleitermodul.

Überdies betrifft die Erfindung ein Verfahren zur Herstellung eines derartigen Halbleitermoduls.

Darüber hinaus betrifft die Erfindung ein Computerprogrammprodukt, umfassend Befehle, die bei einer Ausführung des Programms durch einen Computer diesen veranlassen, ein Verhalten eines derartigen Halbleitermoduls zu simulieren.

In derartigen Stromrichtern werden in der Regel, insbesondere durch ein Gehäuse, abgeschlossene Halbleitermodule beispielweise über eine massive metallische Bodenplatte, auf einen Kühlkörper aufgeschraubt. Unter einem Stromrichter ist beispielsweise ein Gleichrichter, ein Wechselrichter, ein Umrichter oder ein Gleichspannungswandler zu verstehen. Die in den Halbleitermodulen zum Einsatz kommenden Halbleiterelemente sind unter anderem Transistoren, Dioden, Triacs oder Thyristoren. Die Transistoren sind beispielsweise als Insulated-Gate-Bipolar-Transistoren (IGBTs), Feldeffekttransistoren oder Bipolartransistoren ausgeführt. Die Halbleiterelemente sind üblicherweise auf einem Substrat kontaktiert.

Die Offenlegungsschrift WO 2022/002464 A1 beschreibt ein Leistungsmodul mit mindestens zwei Leistungseinheiten, welche jeweils mindestens einen Leistungshalbleiter und ein Substrat umfassen. Um den erforderlichen Bauraum des Leistungsmoduls zu verringern und eine Entwärmung zu verbessern, wird vorgeschlagen, dass der jeweils mindestens eine Leistungshalbleiter, insbesondere stoffschlüssig, mit dem jeweiligen Substrat verbunden ist, wobei die Substrate der mindestens zwei Leistungseinheiten jeweils unmittelbar stoffschlüssig mit einer Oberfläche eines gemeinsamen Kühlkörpers verbunden sind.

Die Offenlegungsschrift US 10,014,238 B2 beschreibt eine elektronische Baugruppe, die ein Wärmemanagementsystem enthält, das einen Kühlkörper mit darauf montierten elektronischen Komponenten umfassen kann. Die elektronischen Komponenten können auf dem Kühlkörper in einer versetzten Anordnung entlang einer Mittellinie im Wesentlichen senkrecht zur Strömungsrichtung eines Kühlmittels montiert werden.

Vor diesem Hintergrund ist es eine Aufgabe der vorliegenden Erfindung, ein Halbleitermodul anzugeben, welches eine verbesserte Zuverlässigkeit aufweist.

Diese Aufgabe wird erfindungsgemäß gelöst durch ein Halbleitermodul mit zumindest einer ersten Halbleiteranordnung, einer zweiten Halbleiteranordnung und einem gemeinsamen Kühlkörper, wobei der Kühlkörper konfiguriert ist, dass ein Kühlfluid in eine Kühlfluidströmungsrichtung geleitet wird, wobei die Halbleiteranordnungen auf einer Oberfläche des Kühlkörpers angeordnet sind, wobei die Halbleiteranordnungen jeweils ein Substrat aufweisen, auf welchem jeweils mindestens ein Halbleiterelement, insbesondere stoffschlüssig, verbunden ist, wobei die Substrate jeweils eine dielektrische Materiallage umfassen, wobei sich eine zweite dielektrische Materiallage der zweiten Halbleiteranordnung von einer ersten dielektrischen Materiallage der ersten Halbleiteranordnung zumindest hinsichtlich ihrer Wärmeleitfähigkeit unterscheidet.

Ferner wird die Aufgabe erfindungsgemäß gelöst durch einen Stromrichter mit mindestens einem derartigen Halbleitermodul. Überdies wird die Aufgabe erfindungsgemäß gelöst durch ein Verfahren zur Herstellung eines derartigen Halbleitermoduls, wobei jeweils mindestens ein Halbleiterelement, insbesondere stoffschlüssig, auf einem Substrat zur Herstellung der Halbleiteranordnungen verbunden wird, wobei in einem weiteren Schritt die Halbleiteranordnungen, insbesondere stoffschlüssig, auf der Oberfläche des Kühlkörpers verbunden werden.

Darüber hinaus wird die Aufgabe erfindungsgemäß gelöst durch ein Computerprogrammprodukt, umfassend Befehle, die bei einer Ausführung des Programms durch einen Computer diesen veranlassen, ein, insbesondere thermisches, mechanisches und/oder elektrisches, Verhalten eines derartigen Halbleitermoduls zu simulieren.

Die in Bezug auf das Halbleitermodul nachstehend angeführten Vorteile und bevorzugten Ausgestaltungen lassen sich sinngemäß auf den Stromrichter, das Verfahren und das Computerprogrammprodukt übertragen.

Der Erfindung liegt die Überlegung zugrunde, die Zuverlässigkeit eines Halbleitermoduls dadurch zu verbessern, dass auf einer Oberfläche eines gemeinsamen Kühlkörper angeordnete Halbleiteranordnungen gleichmäßig entwärmt werden. Die Entwärmung erfolgt über ein Kühlfluid, das in eine Kühlfluidströmungsrichtung geleitet wird. Als Kühlfluid unter anderem gasförmig, beispielsweise Luft, sein. Zusätzlich oder alternativ können auch flüssige Kühlfluide oder eine Phasenwechselkühlung verwendet werden. Die Halbleiteranordnungen weisen jeweils ein Substrat auf, auf welchem mindestens ein Halbleiterelement verbunden ist. Die Halbleiterelemente sind beispielsweise stoffschlüssig, insbesondere durch Löten, Sintern oder Adhäsion, mit dem jeweiligen Substrat verbunden. Die Substrate der Halbleiteranordnungen umfassen jeweils eine dielektrische Materiallage zur Herstellung einer elektrisch isolierenden und thermisch leitenden Verbindung der jeweiligen Halbleiterelemente mit dem gemeinsamen Kühlkörper. Derartige dielektrische Materiallagen können unter anderem einen keramischen Werkstoff enthalten. Um eine gleichmäßige Entwärmung zu erreichen, unterscheidet sich eine zweite dielektrische Materiallage der zweiten Halbleiteranordnung von einer ersten dielektrischen Materiallage der ersten Halbleiteranordnung zumindest hinsichtlich ihrer Wärmeleitfähigkeit. Beispielsweise wird für die zweite Halbleiteranordnung, welche z.B. höhere thermische Verluste aufweist als die erste Halbleiteranordnung, eine zweite dielektrischen Materiallage verwendet, welche eine höhere Wärmeleitfähigkeit aufweist als die erste dielektrischen Materiallage. Somit wird auch bei unterschiedlicher Abwärme eine gleichmäßige Entwärmung erzielt, was sich positiv auf die Zuverlässigkeit des Halbleitermoduls auswirkt und dessen Lebensdauer verlängert.

Ein Computerprogrammprodukt, welches Befehle umfasst, die bei einer Ausführung des Programms durch einen Computer diesen veranlassen, ein, insbesondere thermisches, mechanisches und oder elektrisches, Verhalten des Halbleitermoduls zu simulieren kann einen "digitalen Zwilling", auch "digital twin" genannt, umfassen oder als ein solcher ausgebildet sein. Ein derartiger digitaler Zwilling ist beispielsweise in der Offenlegungsschrift US 2017/0286572 A1 dargestellt. Der Offenbarungsgehalt von US 2017/0286572 A1 wird durch Verweisung in die vorliegende Anmeldung mit einbezogen. Der "digitale Zwilling" ist beispielsweise eine digitale Repräsentanz der für den Betreib des Halbleitermoduls relevanten Komponenten.

Eine weitere Ausführungsform sieht vor, dass die zweite Halbleiteranordnung einem strömungsabwärtigen Ende des Kühlkörpers am nächsten angeordnet ist, wobei die zweite dielektrische Materiallage eine höhere Wärmeleitfähigkeit aufweist als die erste dielektrische Materiallage. Beispielsweise wird der gemeinsame Kühlkörper, z.B. über einen Lüfter, einseitig mit einer Kühlluftströmung versorgt, wobei die Kühlluftströmung von einem strömungsaufwärtigen Ende zu einem strömungsabwärtigen Ende des gemeinsamen Kühlkörpers geleitet wird. Insbesondere ist die zweite Halbleiteranordnung zwischen der ersten Halbleiteranordnung und dem strömungsabwärtigen Ende des gemeinsamen Kühlkörpers angeordnet. Durch die thermischen Verluste der ersten Halbleiteranordnung erwärmt sich das Kühlfluid, wenn es die zweite Halbleiteranordnung erreicht. Durch die höhere Wärmeleitfähigkeit der zweiten dielektrischen Materiallage wird eine gleichmäßigere Entwärmung und somit eine thermische Optimierung erreicht.

Eine weitere Ausführungsform sieht vor, dass das Halbleitermodul zumindest eine dritte Halbleiteranordnung, welche zwischen der ersten Halbleiteranordnung und der zweiten Halbleiteranordnung angeordnet ist, aufweist, aufweisend ein drittes Substrat, auf welchem mindestens ein Halbleiterelement, insbesondere stoffschlüssig, verbunden ist, wobei das dritte Substrat eine dritte dielektrische Materiallage umfasst, wobei sich die dritte dielektrische Materiallage von der ersten dielektrischen Materiallage und/oder der zweiten dielektrischen Materiallage zumindest hinsichtlich ihrer Wärmeleitfähigkeit unterscheidet. Unter anderem können die zumindest drei Halbleiteranordnungen jeweils eine Halbbrücke zur Realisierung eines dreiphasigen Stromrichters, insbesondere bei mehr als drei Halbleiteranordnungen eines Mulilevel-Stromrichters, umfassen. Zusätzlich oder alternativ können Halbleiteranordnungen parallelgeschaltet werden, was eine einfache Skalierung bzw. Modularisierung des Halbleitermoduls ermöglicht.

Eine weitere Ausführungsform sieht vor, dass die zweite dielektrische Materiallage eine höhere Wärmeleitfähigkeit aufweist als die erste dielektrische Materiallage und/oder die dritte dielektrische Materiallage. Durch die höhere Wärmeleitfähigkeit der zweiten dielektrischen Materiallage, welche dem strömungsabwärtigen Ende des Kühlkörpers am nächsten angeordnet ist, wird eine gleichmäßigere Entwärmung und somit eine thermische Optimierung erreicht.

Eine weitere Ausführungsform sieht vor, dass die Halbleiteranordnungen in einem versetzten Muster entlang einer Achse auf einer Oberfläche des Kühlkörpers angeordnet sind, wobei sich die Kühlfluidströmungsrichtung im Wesentlichen entlang der Achse erstreckt. Die Achse kann unter anderem als Strömungsachse bezeichnet werden, wobei die Kühlfluidströmungsrichtung im Wesentlichen parallel zur Strömungsachse verläuft. Beispielsweise sind die Halbleiteranordnungen alternierend, insbesondere mit variablen Abständen, versetzt entlang der Strömungsachse verteilt. Alternierend versetzt bedeutet hier, dass die Halbleiteranordnungen, bezogen auf die Achse, abwechselnd nach links und rechts verschoben sind. Auf diese Weise wird eine gleichmäßigere Entwärmung der Halbleiteranordnungen erreicht.

Eine weitere Ausführungsform sieht vor, dass eine Substratfläche der dem strömungsabwärtigen Ende des Kühlkörpers am nächsten angeordneten Halbleiteranordnung mindestens 20% größer, insbesondere mindestens 50% größer, ist als eine Substratfläche einer weiteren auf der Oberfläche des Kühlkörpers angeordneten Halbleiteranordnung. Auf diese Weise ist eine verbesserte Wärmespreizung erzielbar, wodurch zusätzlich eine gleichmäßigere Entwärmung erreicht wird, was sich positiv auf die Zuverlässigkeit des Halbleitermoduls auswirkt und dessen Lebensdauer verlängert.

Eine weitere Ausführungsform sieht vor, dass eine dem strömungsabwärtigen Ende des Kühlkörpers am nächsten angeordnete Halbleiteranordnung als zumindest ein Teil eines Wechselrichters konfiguriert ist. Insbesondere weist die am strömungsabwärtigen Ende des Kühlkörpers angeordnete Halbleiteranordnung eine dielektrische Materiallage mit einer höheren Wärmeleitfähigkeit auf. Derartige Wechselrichter umfassen schaltbare Halbleiterelemente, insbesondere Transistoren, wie IGBTs, während ein Gleichrichter, der mit einem Wechselrichter einen Umrichter ausbilden kann, mit nicht-schaltbaren Halbleiterelementen, wie Dioden, herstellbar ist. Daher kann es in einem derartigen Wechselrichter während des Betriebes zu einem größeren Temperaturhub bei Stromfluss kommen, wobei eine höhere Wärmeleitfähigkeit der dielektrischen Materiallage den Temperaturhub signifikant reduziert, was sich positiv auf die Lebensdauer des Halbleitermoduls auswirkt.

Eine weitere Ausführungsform sieht vor, dass die Substrate der Halbleiteranordnungen jeweils über eine Verbindungsschicht unmittelbar stoffschlüssig mit der Oberfläche des gemeinsamen Kühlkörpers verbunden sind. Unter einer unmittelbar stoffschlüssigen Verbindung ist eine direkte Verbindung zu verstehen, die Verbindungsmittel zur Herstellung der stoffschlüssigen Verbindung wie Kleber, eine Lötlegierung, Sinterpaste, ... einschließt, ein zusätzliches Verbindungselement wie einen zusätzlichen Leiter, einen Bonddraht, einen Abstandshalter, eine Bodenplatte, Wärmeleitpaste, ... jedoch ausschließt. Durch den Wegfall eines derartigen zusätzlichen Verbindungselements wird eine verbesserte thermische Anbindung der Halbleiterelemente erreicht, sodass eine verbesserte Entwärmung stattfindet. Darüber hinaus wird durch die unmittelbar stoffschlüssige Verbindung Bauraum eingespart.

Eine weitere Ausführungsform sieht vor, dass zumindest die erste dielektrische Materiallage des ersten Substrats Aluminiumoxid und zumindest die zweite dielektrische Materiallage des zweiten Substrats Aluminiumnitrid enthält. Während Aluminiumoxid kostengünstiger ist, wird durch Aluminiumnitrid ein geringerer Beitrag zum Temperaturhub erreicht, sodass der Temperaturhub insgesamt reduziert wird. Beispielsweise trägt Aluminiumoxid zum Temperaturhub 40 K bei, während Aluminiumnitrid nur 36 K beiträgt. Durch die Verwendung des teureren Aluminiumnitrids in der am strömungsabwärtigen Ende des Kühlkörpers angeordneten Halbleiteranordnung wird eine gleichmäßigere Entwärmung erreicht und somit die Lebensdauer des Halbleitermoduls verbessert.

Eine weitere Ausführungsform sieht vor, dass eine erste Verbindungsschicht zur Verbindung des ersten Substrats dünner ist als eine zweite Verbindungsschicht zur Verbindung des zweiten Substrats. Beispielsweise ist die zweite Verbindungsschicht 1,2-mal dicker als die erste Verbindungsschicht. Insbesondere unterscheidet sich der Ausdehnungskoeffizient von Aluminiumnitrid stärker von dem einer metallischen Oberfläche des Kühlkörpers, welche z.B. Kupfer oder Aluminium enthält, als der Ausdehnungskoeffizient von Aluminiumoxid. Eine dickere Verbindungsschicht nimmt mehr Spannungen aufgrund ungleicher Ausdehnungskoeffizienten auf wirkt somit stärker stresspuffernd zwischen der jeweiligen dielektrischen Materiallage und dem metallischen Kühlkörper. Somit wird durch eine dickere zweite Verbindungsschicht ein Durchbiegen des Kühlkörpers aufgrund ungleicher Ausdehnungskoeffizienten verhindert.

Eine weitere Ausführungsform sieht vor, dass eine erste Verbindungsschicht zur Verbindung des ersten Substrats aus einer ersten Legierung und eine zweite Verbindungsschicht zur Verbindung des zweiten Substrats aus einer zweiten Legierung hergestellt sind, wobei sich die erste Legierung von der zweiten Legierung hinsichtlich ihrer Zusammensetzung unterscheidet. Beispielsweise ist die zweite Verbindungsschicht zur Verbindung des zweiten Substrats einer höheren thermischen Belastung ausgesetzt, sodass für die erste Verbindungsschicht zur Verbindung des ersten Substrats eine kostengünstigere und weniger performante Legierung ausreicht.

Eine weitere Ausführungsform sieht vor, dass die zweite Legierung einen höheren Massenanteil Antimon aufweist als die erste Legierung. Beispielsweise wird für die erste Legierung ein günstiges SAC(Zinn/Silber/Kupfer)-Lot verwendet, während für die zweite Legierung zur Verbindung des zweiten Substrats, das einer höheren thermischen Belastung ausgesetzt ist, eine performantere Zinn-Antimon Legierung verwendet wird. Somit wird bei einer hohen Zuverlässigkeit des Halbleitermoduls eine verbesserte Kostenposition erreicht.

Eine weitere Ausführungsform sieht vor, dass die Substrate der Halbleiteranordnungen jeweils eine Dicke von 25 µm bis 400 µm, insbesondere 50 µm bis 250 µm, aufweisen. Eine derartige Dicke stellt einen Kompromiss in Hinblick auf eine thermische Optimierung und eine Durchbiegung des Kühlkörpers dar.

Im Folgenden wird die Erfindung anhand der in den Figuren dargestellten Ausführungsbeispiele näher beschrieben und erläutert.

Es zeigen:
- FIG 1: eine schematische perspektivische Darstellung einer ersten Ausführungsform eines Halbleitermoduls,
- FIG 2: eine schematische Querschnittsdarstellung einer zweiten Ausführungsform eines Halbleitermoduls,
- FIG 3: eine schematische Querschnittsdarstellung einer dritten Ausführungsform eines Halbleitermoduls,
- FIG 4: eine schematische Darstellung einer vierten Ausgestaltung eines Halbleitermoduls in einer Draufsicht,
- FIG 5: eine schematische Darstellung eines Stromrichters mit einem Halbleitermodul.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

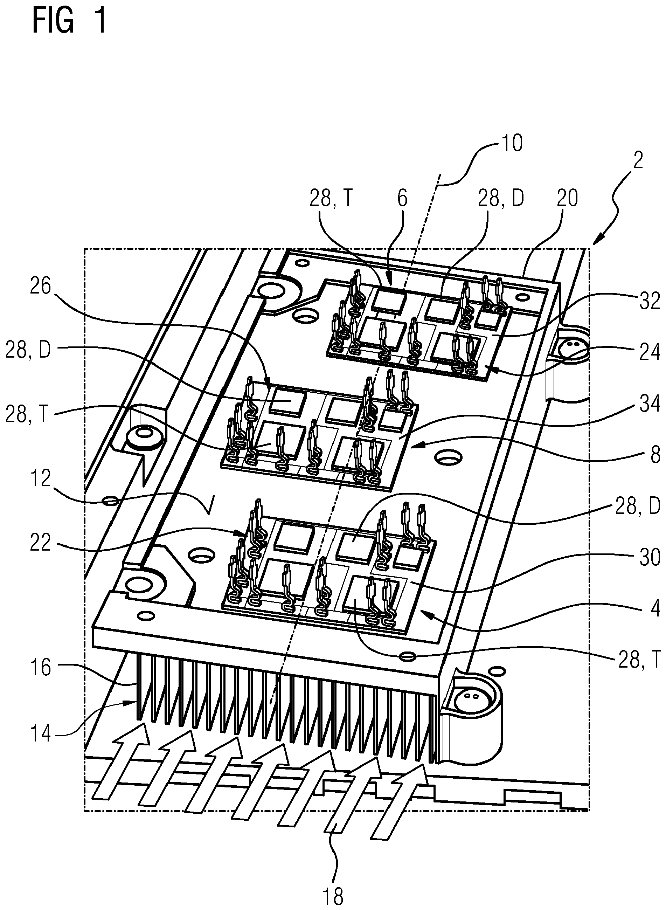

FIG 1 zeigt eine schematische perspektivische Darstellung einer ersten Ausführungsform eines Halbleitermoduls 2, welches eine erste Halbleiteranordnung 4, eine zweite Halbleiteranordnung 6, eine dritte Halbleiteranordnung 8 umfasst, wobei die Halbleiteranordnungen 4, 6, 8 in einem versetzten Muster entlang einer Achse 10 auf einer Oberfläche 12 eines gemeinsamen Kühlkörpers 14 montiert sind. Der gemeinsame Kühlkörper 14 ist durch Kühlrippen 16, welche als Kühlfinnen ausgeführt sind, dafür konfiguriert, dass ein gasförmiges Kühlfluid in eine Kühlmittelströmungsrichtung 18 entlang der Kühlfinnen strömt, wobei sich die Kühlfluidströmungsrichtung 18 im Wesentlichen parallel zur Achse 10 erstreckt. Das Halbleitermoduls 2 wird also einseitig gekühlt.

Die zweite Halbleiteranordnung 6 ist einem strömungsabwärtigen Ende 20 des gemeinsamen Kühlkörpers 14 am nächsten angeordnet. Darüber hinaus umfassen die Halbleiteranordnungen 4, 6, 8 jeweils ein Substrat 22, 24, 26, auf welchen jeweils Halbleiterelemente 28, insbesondere stoffschlüssig, verbunden sind. Beispielhaft sind die Halbleiterelemente 28 als Transistoren T und gegenparallel geschaltete Dioden D ausgeführt. Insbesondere sind die Transistoren T als vertikale Leistungstransistoren, beispielsweise als Insulated-Gate-Bipolar-Transistoren (IGBTs), ausgeführt. Die stoffschlüssige Verbindung der Halbleiterelemente 28 zum jeweiligen Substrat 22, 24, 26 kann unter anderem durch Löten, Sintern oder Adhäsion hergestellt werden.

Die Substrate 22, 24, 26 umfassen jeweils eine, insbesondere beidseitig metallisierte, dielektrische Materiallage 30, 32, 34, über welche die jeweiligen Halbleiterelemente 28 elektrisch isolierend und thermisch leitend mit dem gemeinsamen Kühlkörper 14 verbunden sind. Beispielhaft unterscheidet sich eine zweite dielektrische Materiallage 32 der zweiten Halbleiteranordnung 6 zumindest von einer ersten dielektrischen Materiallage 30 der ersten Halbleiteranordnung 4 hinsichtlich ihrer Wärmeleitfähigkeit. Zusätzlich kann sich eine dritte dielektrische Materiallage 34 der dritten Halbleiteranordnung 8 von der ersten dielektrischen Materiallage 30 und/oder der zweiten dielektrischen Materiallage 6 hinsichtlich ihrer Wärmeleitfähigkeit unterscheiden.

Beispielsweise kann sich das in die Kühlmittelströmungsrichtung 18 strömende Kühlfluid durch die in den Halbleiterelementen 28 der ersten Halbleiteranordnung 4 und dritten Halbleiteranordnung 8 entstehende Verlustwärme aufheizen, sodass eine höhere Wärmeleitfähigkeit der zweiten dielektrischen Materiallage 32 zu einer gleichmäßigeren Kühlung der Halbleiteranordnungen 4, 6, 8 führt. Beispielsweise sind die erste dielektrische Materiallage 30 des ersten Substrats 22 und die dritte dielektrische Materiallage 34 des dritten Substrats 26 aus Aluminiumoxid hergestellt, während die dem strömungsabwärtigen Ende 20 des gemeinsamen Kühlkörpers 14 am nächsten gelegene zweite dielektrische Materiallage 32 des zweiten Substrats 24 aus Aluminiumnitrid, das eine höhere Wärmeleitfähigkeit als Aluminiumoxid aufweist, hergestellt ist. Auf diese Weise werden Temperaturhübe während eines Betriebes des Halbleitermoduls 2, beispielhaft im Bereich der zweiten Halbleiteranordnung 4, reduziert, was sich positiv auf eine Lebensdauer des Halbleitermoduls 2 auswirkt.

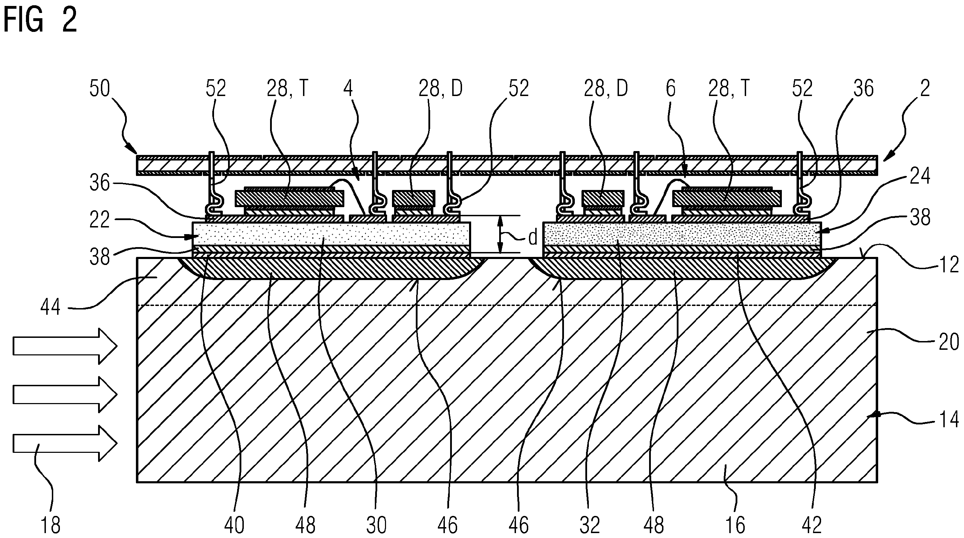

FIG 2 zeigt eine schematische Querschnittsdarstellung einer zweiten Ausführungsform eines Halbleitermoduls 2, welche beispielhaft zwei Halbleiteranordnungen 4, 6 umfasst, wobei die zweite Halbleiteranordnung 6 dem strömungsabwärtigen Ende 20 des Kühlkörpers 14 am nächsten angeordnet ist. Die Substrate 22, 24 weisen jeweils eine Dicke d von 25 µm bis 400 µm, insbesondere 50 µm bis 250 µm auf. Ferner sind sie jeweils aus einer beidseitig metallisierten dielektrischen Materiallage 30, 32 aufgebaut, die einen keramischen Werkstoff enthält. Die erste dielektrische Materiallage 30 des ersten Substrats 22 ist aus Aluminiumoxid hergestellt, während die dem strömungsabwärtigen Ende 20 des gemeinsamen Kühlkörpers 14 am nächsten gelegene zweite dielektrische Materiallage 32 des zweiten Substrats 24 aus Aluminiumnitrid, das eine höhere Wärmeleitfähigkeit als Aluminiumoxid aufweist, hergestellt ist. Über eine erste Metallisierung 36 sind die Halbleiterelemente 28 stoffschlüssig mit dem jeweiligen Substrat 22, 24 verbunden. Darüber hinaus weisen die Substrate 22, 24 der Halbleiteranordnungen 4, 6 auf einer den Halbleiterelementen 28 abgewandten Seite jeweils eine zweite Metallisierung 38 auf, die über eine Verbindungsschicht 40, 42 unmittelbar stoffschlüssig mit der Oberfläche 12 des gemeinsamen Kühlkörpers 14 verbunden sind. Die Halbleiterelemente 28 sind somit über jeweiligen dielektrischen Materiallagen 30, 32 elektrisch isolierend und thermisch leitend mit dem gemeinsamen Kühlkörpers 14 verbunden. Die unmittelbar stoffschlüssige Verbindung über die jeweilige Verbindungsschicht 40, 42 kann unter anderem durch Löten oder Sintern hergestellt werden, es kommen jedoch keine zusätzlichen Verbindungselemente wie Metallblöcke, Bleche oder Wärmeleitpaste zum Einsatz. Die erste Verbindungsschicht 40 zur Verbindung des ersten Substrats 22 ist aus einer ersten Legierung und die zweite Verbindungsschicht 42 zur Verbindung des zweiten Substrats 24 ist aus einer zweiten ersten Legierung hergestellt, wobei sich die erste ersten Legierung von der zweiten Legierung hinsichtlich ihrer Zusammensetzung unterscheidet. Insbesondere enthält die zweite Legierung einen höheren Massenanteil Antimon als die erste Legierung. Beispielsweise ist die erste Legierung ein günstiges SAC(Zinn/Silber/Kupfer)-Lot, während die zweite Legierung eine Zinn-Antimon Legierung ist. Die aus Aluminiumnitrid hergestellte zweite dielektrische Materiallage 32 des zweiten Substrats 24 sorgt aufgrund ihres im Verhältnis zum metallischen Kühlkörper 14 unterschiedlicheren Ausdehnungskoeffizienten, für eine stärke Durchbiegung des Kühlkörpers 14 als die aus Aluminiumoxid hergestellte erste dielektrische Materiallage 30 des ersten Substrats 22, was durch die performantere zweite Legierung zumindest teilweise ausgeglichen wird.

Der Kühlkörper 14 ist aus einem ersten metallischen Werkstoff 44, beispielsweise Aluminium oder einer Aluminiumlegierung, hergestellt. Auf seiner Oberfläche 12 sind Kavitäten 46 eingebracht, die mit einem zweiten metallischen Werkstoff 48 gefüllt sind, der eine höhere Wärmeleitfähigkeit als der erste metallische Werkstoff aufweist. Beispielsweise enthält der zweite metallische Werkstoff 48 Kupfer. Den Halbleiteranordnungen 4,6 ist jeweils eine mit dem zweiten metallischen Werkstoff 48 gefüllte Kavität 46 zugewiesen, wobei der zweite metallische Werkstoff 48 im Wesentlichen planbündig mit der Oberfläche 12 des Kühlkörpers 14 abschließt. Die Verbindungsschichten 40, 42 sind jeweils vollflächig dem zweiten metallischen Werkstoff 48 der Kavitäten 46 verbunden. Insbesondere ist der zweite metallische Werkstoff 48 mittels eines additiven Verfahrens, beispielsweise mittels Kaltgasspritzen, in die Kavitäten 46 eingebracht. Den Halbleiteranordnungen 4,6 kann jeweils ein dedizierter Sensor, insbesondere Temperatursensor, zugewiesen sein, um die Temperatur der Halbleiterelemente 28 zu überwachen.

Ein im Wesentlichen parallel zur Oberfläche 12 des Kühlkörpers 14 verlaufend angeordnetes Power-Board 50 ist über frei positionierbare Kontakte 52 mit den Halbleiteranordnungen 4, 6 verbunden, wobei die frei positionierbaren Kontakte 52 stoffschlüssig mit den ersten Metallisierungen 36 der jeweiligen Substrate 22, 24 der Halbleiteranordnungen 4, 6 verbunden sind. Unter einem Power-Board 50 ist in diesem Zusammenhang eine Leiterplatte zu verstehen, welche z.B. als, insbesondere mehrlagig ausgeführtes, Printed-Circuit-Board (PCB) ausgeführt ist. Die Leiterplatte enthält beispielsweise eine Schnittstelle zu den Leistungseinheiten, eine Treiberschaltung, eine Ansteuerschaltung, und/oder Kondensatoren. Unter einem frei positionierbaren Kontakt 52 ist in diesem Zusammenhang unter anderem ein Pin zu verstehen, der durch seine strukturellen Eigenschaften frei auf einem Substrat 22, 24 angeordnet werden kann. Derartige strukturelle Eigenschaften sind beispielsweise ein Fuß, der es dem Pin, beispielsweise durch eine stoffschlüssige Verbindung mit dem Substrat, erlaubt, ohne ein Gehäuse oder andere Stabilisierungsmittel frei und stabil auf dem Substrat angeordnet zu werden und/oder ein Taumelkreis, der eine Findung einer Bohrung im Power-Board 50 erleichtert und für mehr Stabilität und Robustheit, z.B. bei einer thermischen Ausdehnung während des Betriebes, sorgt. Die frei positionierbaren Kontakte 52 weisen einen elastisch nachgebenden Abschnitt auf und sind beispielsweise mit einer Presspass-Verbindung mit dem Power-Board 50 verbunden. Die weitere Ausführung des Halbleitermoduls 2 in FIG 2 entspricht der Ausführung in FIG 1.

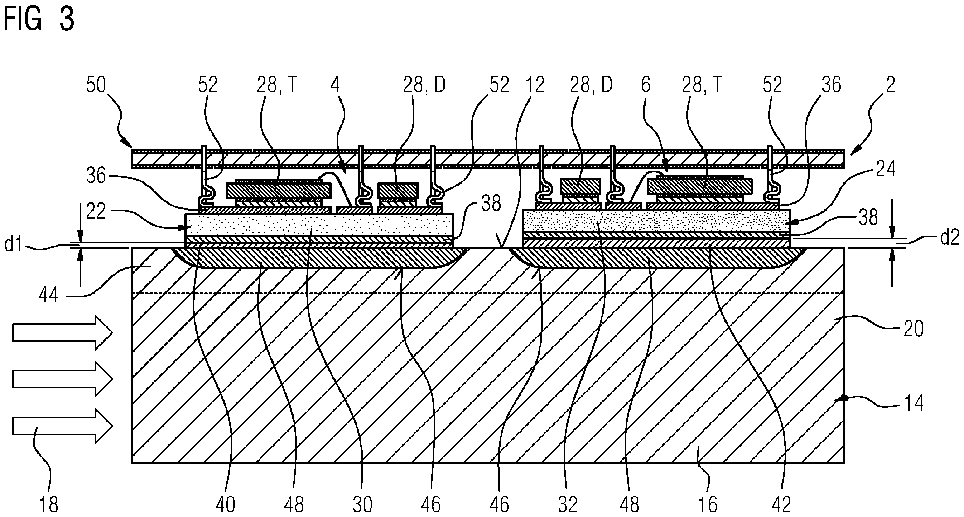

FIG 3 zeigt eine schematische Querschnittsdarstellung einer dritten Ausführungsform eines Halbleitermoduls 2. Die erste dielektrische Materiallage 30 des ersten Substrats 22 ist aus Aluminiumoxid hergestellt, während die dem strömungsabwärtigen Ende 20 des gemeinsamen Kühlkörpers 14 am nächsten gelegene zweite dielektrische Materiallage 32 des zweiten Substrats 24 aus Aluminiumnitrid hergestellt ist. Die erste Verbindungsschicht 40 zur Verbindung des ersten Substrats 22 weist eine erste Dicke d1 auf, während die zweite Verbindungsschicht 42 zur Verbindung des zweiten Substrats 24 eine zweite Dicke d2 aufweist, wobei die zweite Dicke d2 der zweiten Verbindungsschicht 42 größer als die erste Dicke d1 der ersten Verbindungsschicht 40 ist. Insbesondere ist die zweite Dicke d2 1,2-mal bzw. 20 % größer als die erste Dicke d1. Die aus Aluminiumnitrid hergestellte zweite dielektrische Materiallage 32 sorgt aufgrund ihres im Verhältnis zum metallischen Kühlkörper 14 unterschiedlicheren Ausdehnungskoeffizienten, für eine stärke Durchbiegung des Kühlkörpers 14 als die aus Aluminiumoxid hergestellte erste dielektrische Materiallage 30, was durch die dickere zweite Verbindungsschicht 42 zumindest teilweise ausgeglichen wird. Die dickere zweite Verbindungsschicht wirkt somit stärker als stresspuffernde Schicht zwischen der jeweiligen dielektrischen Materiallage 30, 32 und dem metallischen Kühlkörper 14. Die weitere Ausführung des Halbleitermoduls 2 in FIG 3 entspricht der Ausführung in FIG 2.

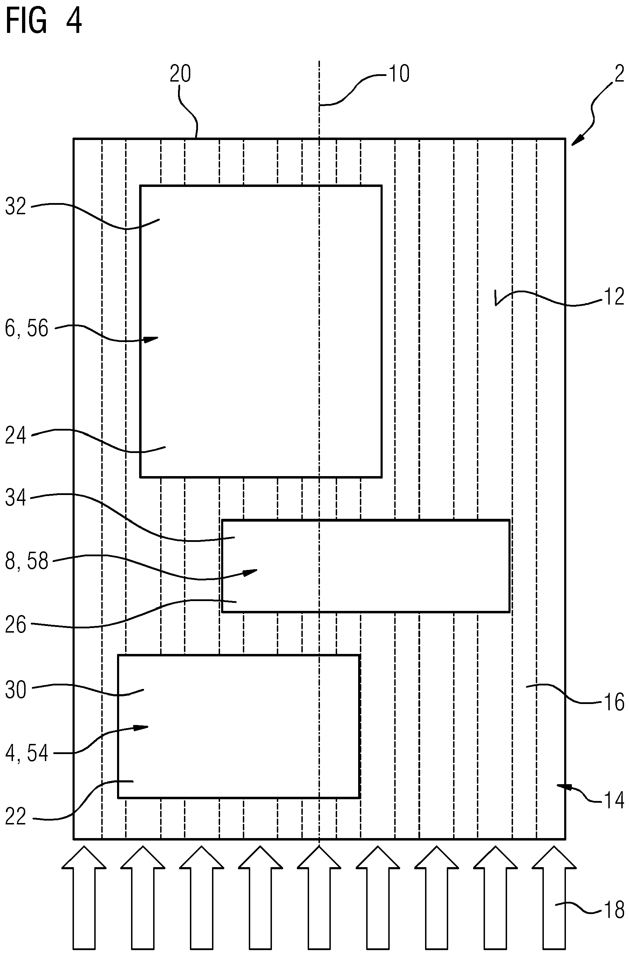

FIG 4 zeigt eine schematische Darstellung einer vierten Ausgestaltung eines Halbleitermoduls 2 in einer Draufsicht, welches beispielhaft drei Halbleiteranordnungen 4, 6, 8 aufweist, wobei die Halbleiteranordnungen 4, 6, 8 in einem versetzten Muster entlang einer Achse 10 auf der Oberfläche 12 des Kühlkörpers 14 angeordnet sind. Die zweite Halbleiteranordnung 6 ist dem strömungsabwärtigen Ende 20 des Kühlkörpers 14 am nächsten angeordnet. Bezogen auf die Achse 10 ist die dritte Halbleiteranordnung 8 zwischen der ersten Halbleiteranordnung 4 und der zweiten Halbleiteranordnung 6 angeordnet. Die erste Halbleiteranordnung 4 ist als ein, insbesondere dreiphasiger, Gleichrichter 54 konfiguriert, während die zweite Halbleiteranordnung 6 als ein, insbesondere dreiphasiger, Wechselrichter 56 konfiguriert ist. Die dritte Halbleiteranordnung 8 ist als eine Überwachungsvorrichtung 58, z.B. einer Zwischenkreisspannung, insbesondere als Bremschopper, konfiguriert. Der Wechselrichter 56 umfasst schaltbare Halbleiterelemente wie Transistoren, insbesondere IGBTs, währen im Gleichrichter Dioden zum Einsatz kommen. Eine Substratfläche des Wechselrichters 56 ist mindestens 1,5-Mal, insbesondere 2-Mal so groß wie eine Substratfläche des Gleichrichters 54 bzw. der Überwachungsvorrichtung 58. Die dielektrische Materiallage 32 des Wechselrichters 56 ist aus Aluminiumnitrid hergestellt, während die dielektrischen Materiallagen 30, 34 des Gleichrichters 54 und der Überwachungsvorrichtung 58 aus kostengünstigerem Aluminiumoxid hergestellt sind. Die weitere Ausführung des Halbleitermoduls 2 in FIG 4 entspricht der Ausführung in FIG 3.

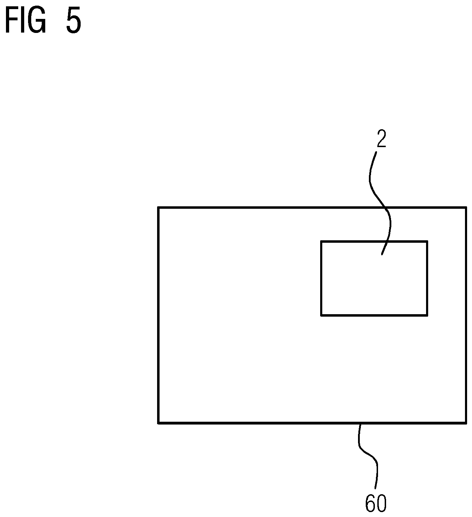

FIG 5 zeigt eine schematische Darstellung eines Stromrichters 60 mit einem Halbleitermodul 2. Der Stromrichters 60 kann mehr als ein Halbleitermodul 2 umfassen.

Zusammenfassend betrifft die Erfindung ein Halbleitermodul 2 mit zumindest einer ersten Halbleiteranordnung 4, einer zweiten Halbleiteranordnung 6 und einem gemeinsamen Kühlkörper 14, wobei der Kühlkörper 14 konfiguriert ist, dass ein Kühlfluid in eine Kühlfluidströmungsrichtung 18 geleitet wird, wobei die Halbleiteranordnungen 4, 6 auf einer Oberfläche 12 des Kühlkörpers 14 angeordnet sind, wobei die Halbleiteranordnungen 4, 6 jeweils ein Substrat 22, 24 aufweisen, auf welchem jeweils mindestens ein Halbleiterelement 28, insbesondere stoffschlüssig, verbunden ist, wobei die Substrate 22, 24 jeweils eine dielektrische Materiallage 30, 32 umfassen. Um eine verbesserte Zuverlässigkeit zu erreichen, wird vorgeschlagen, dass sich eine zweite dielektrische Materiallage 32 der zweiten Halbleiteranordnung 6 von einer ersten dielektrischen Materiallage 30 der ersten Halbleiteranordnung 4 zumindest hinsichtlich ihrer Wärmeleitfähigkeit unterscheidet.

## Patentansprüche

1. Halbleitermodul (2) mit zumindest einer ersten Halbleiteranordnung (4), einer zweiten Halbleiteranordnung (6) und einem gemeinsamen Kühlkörper (14),
wobei der Kühlkörper (14) konfiguriert ist, dass ein Kühlfluid in eine Kühlfluidströmungsrichtung (18) geleitet wird, wobei die Halbleiteranordnungen (4, 6) auf einer Oberfläche (12) des Kühlkörpers (14) angeordnet sind,
wobei die Halbleiteranordnungen (4, 6) jeweils ein Substrat (22, 24) aufweisen, auf welchem jeweils mindestens ein Halbleiterelement (28), insbesondere stoffschlüssig, verbunden ist,
wobei die Substrate (22, 24) jeweils eine dielektrische Materiallage (30, 32) umfassen,
**dadurch gekennzeichnet, dass**
sich eine zweite dielektrische Materiallage (32) der zweiten Halbleiteranordnung (6) von einer ersten dielektrischen Materiallage (30) der ersten Halbleiteranordnung (4) zumindest hinsichtlich ihrer Wärmeleitfähigkeit unterscheidet.

2. Halbleitermodul (2) nach Anspruch 1,
wobei die zweite Halbleiteranordnung (6) einem strömungsabwärtigen Ende (20) des Kühlkörpers (14) am nächsten angeordnet ist,
wobei die zweite dielektrische Materiallage (32) eine höhere Wärmeleitfähigkeit aufweist als die erste dielektrische Materiallage (30).

3. Halbleitermodul (2) nach einem der Ansprüche 1 oder 2, aufweisend zumindest eine dritte Halbleiteranordnung (8), welche zwischen der ersten Halbleiteranordnung (4) und der zweiten Halbleiteranordnung (6) angeordnet ist, aufweisend ein drittes Substrat (26), auf welchem mindestens ein Halbleiterelement (28), insbesondere stoffschlüssig, verbunden ist,
wobei das dritte Substrat (26) eine dritte dielektrische Materiallage (34) umfasst,
wobei sich die dritte dielektrische Materiallage (34) von der ersten dielektrischen Materiallage (30) und/oder der zweiten dielektrischen Materiallage (32) zumindest hinsichtlich ihrer Wärmeleitfähigkeit unterscheidet.

4. Halbleitermodul (2) nach Anspruch 3,
wobei die zweite dielektrische Materiallage (32) eine höhere Wärmeleitfähigkeit aufweist als die erste dielektrische Materiallage (30) und/oder die dritte dielektrische Materiallage (34).

5. Halbleitermodul (2) nach einem der vorherigen Ansprüche, wobei die Halbleiteranordnungen (4, 6, 8) in einem versetzten Muster entlang einer Achse (10) auf einer Oberfläche (12) des Kühlkörpers (14) angeordnet sind,
wobei sich die Kühlfluidströmungsrichtung (18) im Wesentlichen entlang der Achse (10) erstreckt.

6. Halbleitermodul (2) nach einem der vorherigen Ansprüche, wobei eine Substratfläche der dem strömungsabwärtigen Ende (20) des Kühlkörpers (14) am nächsten angeordneten Halbleiteranordnung (4, 6, 8) mindestens 20% größer, insbesondere mindestens 50% größer, ist als eine Substratfläche einer weiteren auf der Oberfläche (12) des Kühlkörpers (14) angeordneten Halbleiteranordnung (4, 6, 8).

7. Halbleitermodul (2) nach einem der vorherigen Ansprüche, wobei eine dem strömungsabwärtigen Ende (20) des Kühlkörpers (14) am nächsten angeordnete Halbleiteranordnung (4, 6, 8) als zumindest ein Teil eines Wechselrichters konfiguriert ist.

8. Halbleitermodul (2) nach einem der vorherigen Ansprüche, wobei die Substrate (22, 24, 26) der Halbleiteranordnungen (4, 6, 8) jeweils über eine Verbindungsschicht (40, 42) unmittelbar stoffschlüssig mit der Oberfläche (12) des gemeinsamen Kühlkörpers (14) verbunden sind.

9. Halbleitermodul (2) nach Anspruch 8,
wobei zumindest die erste dielektrische Materiallage (30) des ersten Substrats (22) Aluminiumoxid und zumindest die zweite dielektrische Materiallage (32) des zweiten Substrats (24) Aluminiumnitrid enthält.

10. Halbleitermodul (2) nach Anspruch 9,
wobei eine erste Verbindungsschicht (40) zur Verbindung des ersten Substrats (22) dünner ist als eine zweite Verbindungsschicht (42) zur Verbindung des zweiten Substrats (24).

11. Halbleitermodul (2) nach einem der Ansprüche 9 oder 10, wobei eine erste Verbindungsschicht (40) zur Verbindung des ersten Substrats (22) aus einer ersten Legierung und eine zweite Verbindungsschicht (42) zur Verbindung des zweiten Substrats (24) aus einer zweiten ersten Legierung hergestellt sind,
wobei sich die erste ersten Legierung von der zweiten Legierung hinsichtlich ihrer Zusammensetzung unterscheidet.

12. Halbleitermodul (2) nach Anspruch 11,
wobei die zweite Legierung einen höheren Massenanteil Antimon aufweist als die erste Legierung.

13. Halbleitermodul (2) nach einem der vorherigen Ansprüche, wobei die Substrate (22, 24, 26) der Halbleiteranordnungen (4, 6, 8) jeweils eine Dicke d von 25 µm bis 400 µm, insbesondere 50 µm bis 250 µm, aufweisen.

14. Stromrichter (60) mit mindestens einem Halbleitermodul (2) nach einem der vorherigen Ansprüche.

15. Verfahren zur Herstellung eines Halbleitermoduls (2) nach einem der Ansprüche 1 bis 12,
wobei jeweils mindestens ein Halbleiterelement (28), insbesondere stoffschlüssig, auf einem Substrat (22, 24, 26) zur Herstellung der Halbleiteranordnungen (4, 6, 8) verbunden wird,
wobei in einem weiteren Schritt die Halbleiteranordnungen (4, 6, 8), insbesondere stoffschlüssig, auf der Oberfläche (12) des Kühlkörpers (14) verbunden werden.

16. Computerprogrammprodukt, umfassend Befehle, die bei einer Ausführung des Programms durch einen Computer diesen veranlassen, ein, insbesondere thermisches, mechanisches und/oder elektrisches, Verhalten eines Halbleitermoduls (2) nach einem der Ansprüche 1 bis 12 zu simulieren.
